(19) **Europäisches Patentamt**
**European Patent Office**
**Office européen des brevets**

(11) **EP 1 783 918 A2**

(12) **EUROPEAN PATENT APPLICATION**

(43) Date of publication:
**09.05.2007 Bulletin 2007/19**

(51) Int Cl.:
**H03M 13/41** *(2006.01)*

(21) Application number: **06120671.0**

(22) Date of filing: **14.09.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **07.11.2005 KR 20050106057**

(71) Applicant: **Samsung Electronics Co., Ltd.**
**Suwon-si, Gyeonggi-Do (KR)**

(72) Inventors:
- **Lee, Jeong-sang**
  **Yeongdeungpo-gu,**
  **Seoul (KR)**
- **Kong, Jun-jin**
  **Suji-gu,**
  **Yongin-si,**
  **Gyeonggi-do (KR)**

(74) Representative: **Grünecker, Kinkeldey, Stockmair & Schwanhäusser Anwaltssozietät**
**Maximilianstrasse 58**
**80538 München (DE)**

(54) **Viterbi decoding method and apparatus for high speed data transmissions**

(57) Disclosed are a Viterbi decoding method and apparatus for high speed data transmissions. Branch metric is used with data inputted from a Viterbi decoder used in a communication system, and, when current state metric is used for addition, comparison, and selection, the selection operation is performed after simultaneous addition and comparison operations are performed, so that a faster decoding processing speed is obtained. The decoding process is carried out at a high speed with the addition and comparison operations carried out simultaneously, thereby preventing the increase of power consumption.

FIG. 2

EP 1 783 918 A2

**Description**

FIELD OF THE INVENTION

The present invention relates to a Viterbi decoding method and apparatus for high speed data transmissions. More particularly, the present invention relates to a Viterbi decoding method and apparatus for high speed data transmissions wherein branch metric is used with data inputted from a Viterbi decoder used in a communication system, and, when current state metric is used for addition, comparison, and selection, the selection operation is performed after simultaneous addition and comparison operations, so that a faster decoding processing speed is obtained.

BACKGROUND OF THE INVENTION

Generally, in a system that uses an air interface as a communication channel, the transmitter side encodes and transmits data through a convolutional encoder, and a receiver side corrects errors and decodes data using a Viterbi decoder, in order to overcome the errors caused by noise occurring during communications.

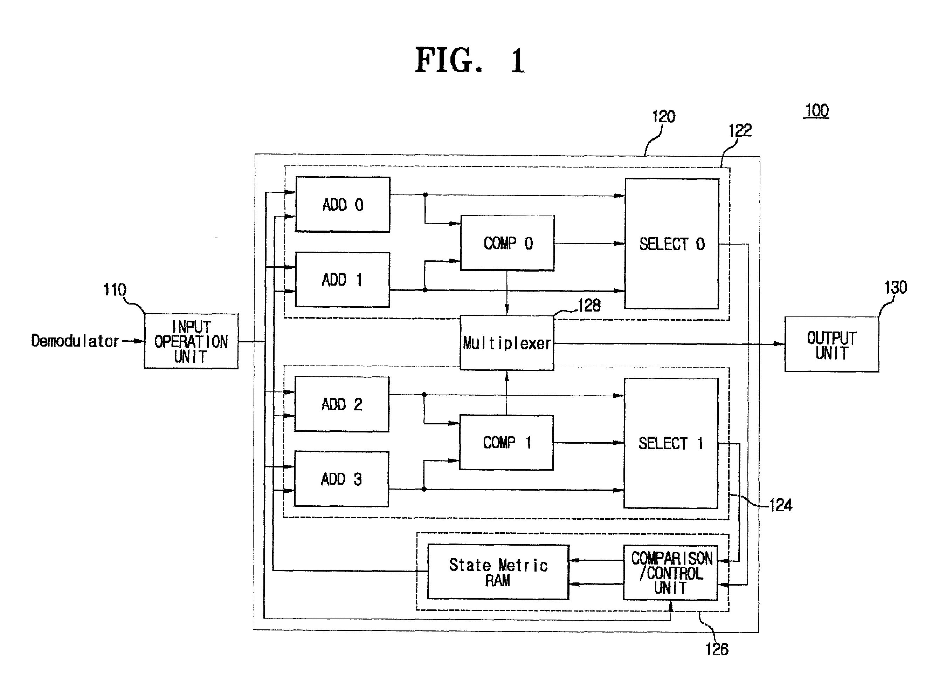

In exemplary embodiments of the present invention, , discussions have been made on approaches of using the Viterbi decoder with input data and specifying branch metric, storing current state metric selected through addition and comparison of a specified result to and with an established value, and reducing the number of times a state metric RAM is accessed, and using the stored data as a previous state in subsequent additions, comparisons, and selections, thereby reducing an overall processing speed. FIG. 1 is a block diagram for schematically showing a configuration of a conventional Viterbi decoder.

A conventional Viterbi decoder 100 has an input operation unit 110, addition/comparison/selection unit 120, and output unit 130.

The input operation unit 110 receives the output data of a demodulator (not shown), calculates a branch metric, and outputs output data BM0 to BM3.

The addition/comparison/selection unit 120 inputs and adds the output data BM0 to BM3 of the input operation unit 110 to a previous state metric (PSM) previously established, and forms current state metrics (CSM), selects and stores a smaller current state metric (CSM), and selects and outputs comparison information when outputting the value as a previous state metric (PSM) in a subsequent state.

The output unit 130 receives the comparison information of the addition/comparison/selection unit 120, checks errors of received data, and decodes and outputs the data.

Further, the addition/comparison/selection unit 120 includes a first addition/comparison/selection block 122, a second addition/comparison/selection block 124, state metric storage unit 126, and multiplexer 128.

The first and second addition/comparison/selection blocks 122 and 124 respectively receive output data BM2 and BM3 of the input operation unit 110 and add the data to the previously established previous state metric PSM so as to create a current state metric (CSM), compare the current state metrics with each other, and select and output a smaller current state metric (CSM).

The state metric storage unit 126 receives and stores output data of the first and second addition/ comparison/ selection blocks 122 and 124, and selectively outputs the stored output data to the inputs of the first and second addition/ comparison/selection blocks 122 and 124 as previous state metrics.

Next, the multiplexer 128 receives and outputs the results of data comparisons from the first and second addition/comparison/selection blocks 122 and 124, respectively, as comparison information.

In the Viterbi decoder 100 configured as above, the adders ADD0 to ADD3 of the first and second addition/ comparison/selection blocks 122 and 124 respectively receive, add, and output a previous state metric (PSM) and the output data BM0 to BM3 of the input operation unit 110. The comparators COMPO and COMP1 that receive the outputted data respectively compare the output values of the adders ADD0 and ADD 1 and the adders ADD2 and ADD3, and simultaneously outputs to the selection units SELECT0 and SELECT1 and inputs to the multiplexer 128 the information of a smaller value of the output values.

The selection unit SELECT0 then selects and outputs either the adder ADD0 or the adder ADD1 dependent on which current state metric CSM has a smaller output signal, and the selection unit SELECT1 selects and outputs either the adder ADD2 or the adder ADD3 dependent on which current state metric CSM has a smaller output signal, according to the output signals of the comparison units COMPO and COMP1.

Next, the current state metrics selected by the selection units SELECT0 and SELECT1 are stored in the state metric RAM and, when subsequent data are inputted through the input operation unit 110, the stored value is outputted to the adders ADD0 to ADD3 for additions, comparisons, selections, and storage as to the subsequent data in the same manner, the operations of which are repeated as many times as needed.

Accordingly, the conventional Viterbi decoder 100 has a slow decoding speed, since the addition, comparison, and selection procedures are sequentially processed as described above. Additionally, the conventional Viterbi decoder has an increased power consumption, since the number of times the state metric RAM is accessed is more than is needed since write and read operations to and from the state metric RAM are performed every time a state is calculated.

## SUMMARY OF THE INVENTION

The present invention has been developed in order to address the above drawbacks and other problems associated with the conventional arrangement. An aspect of the present invention is to provide a Viterbi decoding method and apparatus for high speed data transmissions wherein branch metric is used with data inputted from a Viterbi decoder used in a communication system, and, when current state metric is used for addition, comparison, and selection, the selection operation is performed after the simultaneous addition and comparison operations, so that a faster decoding processing speed is obtained.

The foregoing and other aspects and advantages are substantially realized by providing a Viterbi decoding method, comprising performing branch metric calculations with input data, and outputting output data; simultaneously performing additions and comparisons of the output data by using a fed-back previous state metric; selecting a minimum value from a result of the simultaneous additions and comparisons; and checking errors of the inputted data by executing a trace-back algorithm and decoding the data.

In performing additions and comparisons, the additions are performed in a Carry Look-ahead Adder (CLA) by three bits, and the result is processed in a Carry SeLect Adder (CSLA)

The three-bit CLA is configured with a CLA0 indicating that an LSB input is "0" and a CLA1 indicating that the input is "1", and the addition of three bits is carried out at the same time, and a result of which is selected by a multiplexer.

In performing additions and comparisons, the comparisons are performed based on subtractions with use of carry-save (CS) addition and comparing two input data through MSB of a result of the subtractions.

The foregoing and other objects and advantages are substantially realized by providing a Viterbi decoding apparatus comprising an input operation unit for performing branch metric calculations with input data, and outputting output data; an addition/comparison unit for simultaneously performing additions and comparisons of the output data by using a fed-back previous state metric; a selection unit for selecting a minimum value from a result of the simultaneous additions and comparisons; and an output unit for checking errors of the inputted data by executing a trace-back algorithm, and decoding the data.

The addition/comparison unit is constructed with adders and comparators connected in parallel, and the adders are performed in a CLA by three bits, and a result of which is processed in a CSLA.

The three-bit CLA is configured with a CLA0 indicating that an LSB input is "0" and a CLA1 indicating that the input is "1", and the addition of three bits is carried out at the same time, and a result of which is selected by a multiplexer.

The comparators are constructed with CS adders.

## BRIEF DESCRIPTION OF THE DRAWINGS

The above aspects and features of the present invention will be more apparent by describing certain exemplary embodiments of the present invention with reference to the accompanying drawings, in which:

FIG. 1 is a block diagram for schematically showing a configuration of a conventional Viterbi decoder;

FIG. 2 is a block diagram for schematically showing a configuration of a Viterbi decoding apparatus according to an exemplary embodiment of the present invention;

FIG. 3 is a view for showing an internal configuration of an adder; and

FIG. 4 is a view for showing an internal configuration of each comparator of a comparison unit.

## DETAILED DESCRIPTION OF THE EXEMPLARY EMBODIMENTS

Hereinafter, description will be made in detail on preferred exemplary embodiments of the present invention with reference to the accompanying drawings.

It is noted that like reference numerals are used to denote like parts or elements even though shown in different drawings in assigning the reference numerals to constituent parts or elements of each drawing.

For purposes of simplification, detailed description of well-known structures or functions will be avoided if it is understood that concrete description of such structures or functions is not necessary for understanding the present invention.

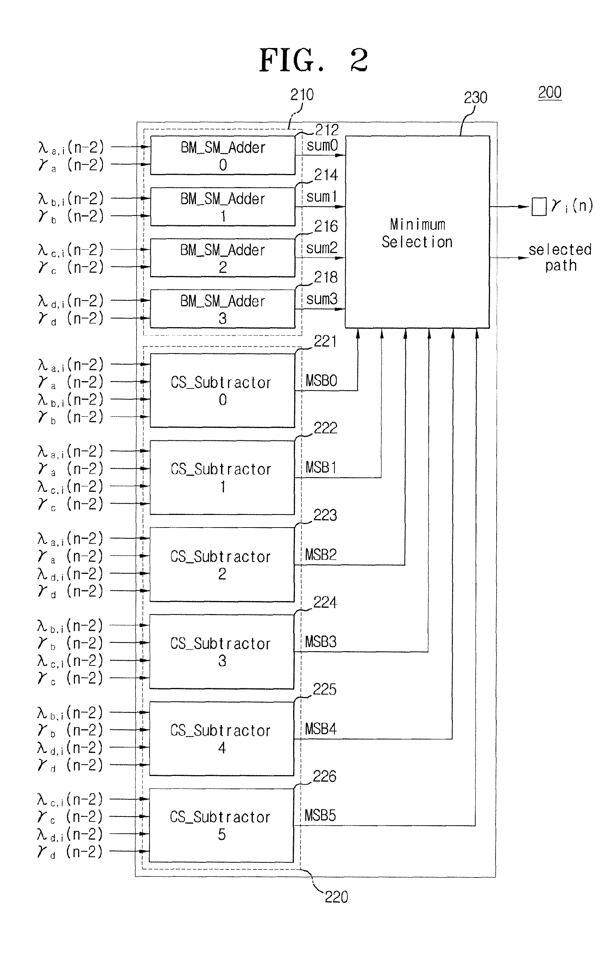

FIG. 2 is a block diagram for schematically showing a configuration of a Viterbi decoding apparatus according to an exemplary embodiment of the present invention.

The Viterbi decoding apparatus 200 according to an exemplary embodiment of the present invention has an addition unit 210 and a comparison unit 220 which are disposed in parallel, and is configured for the outputs of the addition unit 210 and the comparison unit 220 to be inputted into a selection unit 230 at the same time. Since the input operation unit 110 was described above, it is not shown in FIG 2.

The addition unit 210 has a configuration having a first adder 212, a second adder 214, a third adder 216, and a fourth adder 218. The first adder 212 outputs a first sum value sum0 for two inputs $\lambda_{a,i}(n$-2$)$ and $\gamma a(n$- 2$)$; he second adder 214 outputs a second sum value sum1 for two inputs $\lambda_{b,i}(n$-2$)$ and $\gamma_b(n$-2$)$; he third adder 216 outputs a third sum value sum2 for two inputs $\lambda_{c,i}(n$-2$)$ and $\gamma_c(n$-2$)$ , and he fourth adder 218 outputs a fourth sum value sum3 for two inputs $\lambda_{d,i}(n$-2$)$ and $\gamma_d(n$-2$)$.

The comparison unit 220 has a configuration having a first comparator (Substractor0) 221, a second comparator 222, a third comparator 223, a fourth comparator 224, a fifth comparator 225, and a sixth comparator 226.

In the exemplary embodiment of the present invention, the first comparator 221 outputs a first comparison value MSB0 for four inputs $\lambda_{a,i}(n$-2$)$, $\gamma_a(n$-2$)$, $\lambda_{b,i}(n$-2$)$, and $\gamma_b(n$-2$)$; the second comparator 222 outputs a second comparison value MSB1 1 for four inputs $\lambda_{a,i}(n$-2$)$, $\gamma_a(n$-2$)$, $\lambda_{c,i}(n$-2$)$, and $\gamma_c(n$-2$)$; the third comparator 223 outputs a third comparison value MSB2 for four inputs $\lambda_{a,i}(n$-2$)$, $\gamma_a(n$-2$)$, $\lambda_{d,i}(n$-2$)$, and $\gamma_d(n$-2$)$ ; the fourth comparator 224 outputs a fourth comparison value MSB3 for four inputs $\lambda_{b,i}(n$-2$)$, $\gamma_b(n$-2$)$, $\lambda_{c,i}(n$-2$)$, and $\gamma_c(n$-2$)$; the fifth comparator 225 outputs a fifth comparison value MSB4 for four inputs $\lambda_{b,i}(n$-2$)$, $\gamma_b(n$-2$)$, $\lambda_{d,i}(n$-2$)$, and $\gamma_d(n$-2$)$, and the sixth comparator 226 outputs a sixth comparison value MSB5 for four inputs $\lambda_{c,i}(n$-2$)$, $\gamma_c(n$-2$)$, $\lambda_{d,i}(n$-2$)$, and $\gamma_d(n$-2$)$.

The Viterbi decoding apparatus 200 according to the present invention may use offset binary numbers rather than redundant number representation.

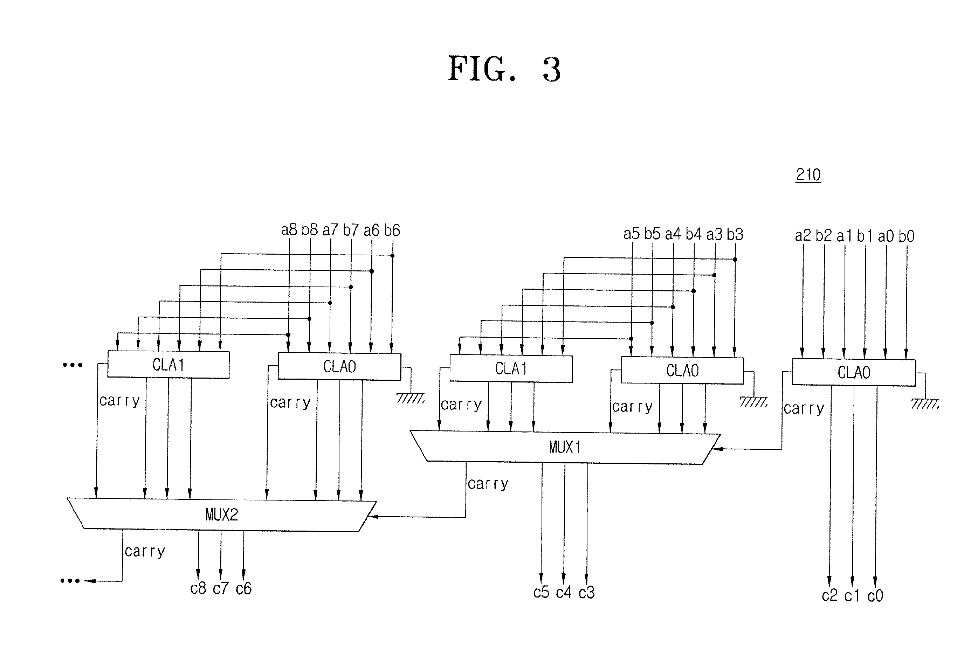

FIG. 3 is a view for showing the internal configuration of an addition unit.

As shown in FIG. 3, the addition unit 210 according to the present invention processes input data by three bits at a time, using a (Carry Look-Ahead Adder) (CLA), and processes the result, using a Carry SeLect Adder (CSLA)).

In the present invention, each CLA is constructed with a CLA0 indicating that the carry input of the LSB is "0" and a CLA1 indicating that the carry input of the LSB is "1".

Further, the addition of every three bits is processed at a time, and the result is selected by the multiplexers MUX1 and MUX2. The MSB (carry out) of the addition result of the lower three bits is in charge of the controls of the multiplexers.

In FIG 3, inputs a0, b0, a1, b1, a2, and b2 are inputted into the CLA0, and c0, c1, and c2 are outputted, and carries are applied to the multiplexer MUX1 when carries are generated. Inputs a3, b3, a4, b4, a5, and b5 are inputted into both the CLA0 and the CLA1, and all the outputs and carries of the CLA0 and the CLA1 are inputted into the multiplexer MUX1. Multiplexer MUX1 outputs c5, c4, and c3, and the carries are applied to the next multiplexer MUX2. Inputs a6, b6, a7, b7, a8, and b8 are inputted into both the CLA0 and the CLA1, and all the outputs and carries of the CLA0 and the CLA1 are inputted into the second multiplexer MUX2, the second multiplexer MUX2 outputs c6, c7, and c8 together with a carry.

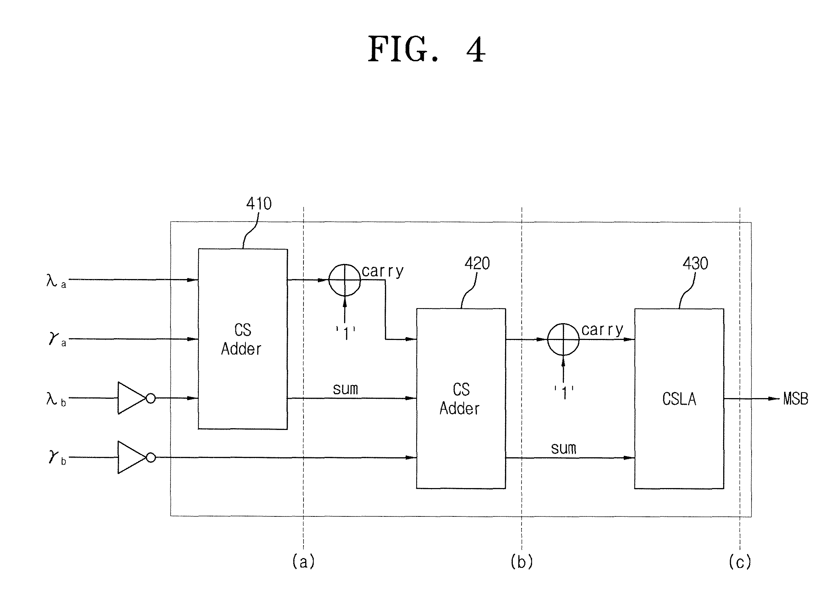

FIG. 4 is a view for showing the internal configuration of each comparator in the comparison unit.

As shown in FIG. 4, the comparator according to the present invention performs comparisons through subtractions so as to operate in the same manner as an adder in a functional aspect, and uses a Carry-Saver (CS) adder for such a subtraction function.

In FIG 4, if inputs $\lambda_a$, $\gamma_a$, and $\lambda_b$ are inputted into a first CS adder 410, the first CS adder 410 outputs a result as shown in Equation 1 at a point (a).

[Equation 1]

$$(a) = \lambda_a + \gamma_a + \left(-\lambda_a\right)$$

Further, if the output of the first CS adder 410 and the input signal $\gamma_a$ are inputted into a second CS adder 420, the second CS adder 420 outputs a result as shown in Equation 2 at a point (b).

[Equation 2]

$$(b) = \lambda_a + \gamma_a + \left(-\lambda_b + 1\right) + \left(-\gamma_b\right)$$

Further, if the output and the carry of the second CS adder 420 are inputted into a third CS adder 430, the third CS adder 430 outputs a result as shown in Equation 3 at a point (c).

[Equation 3]

$$(c) = \lambda_a + \gamma_a + (-\lambda_b + 1) + (-\gamma_b + 1)$$

As described above, the values outputted through the addition unit 210 and the comparison unit 220 are inputted into the selection unit 230. Accordingly, the selection unit 230 operates in the manner as shown Equation 4, and outputs a minimum value MSB.

[Equation 4]

$$\text{if (MSB0==0 \&\& MSB1==0 \&\& MSB2==0)}$$

$$\text{Yi(n) = sum0;}$$

$$\text{selected path = 0;}$$

$$\text{else if (MSB0==1 \&\& MSB3==0 \&\& MSB4==0)}$$

$$\text{Yi(n) = sum1;}$$

$$\text{selected path = 1;}$$

$$\text{else if (MSB1==1 \&\& MSB3==1 \&\& MSB5==0)}$$

$$\text{Yi(n) = sum2;}$$

$$\text{selected path = 2;}$$

$$\text{else}$$

$$\text{Yi(n) = sum3;}$$

$$\text{selected path = 3;}$$

As explained above, the present invention carries out the decoding process at a high speed with the addition and comparison operations carried out simultaneously, thereby bringing out an effect capable of preventing the increase of power consumption.

The aforementioned is merely an illustrative description on the technical spirit of the present invention, and various changes and modifications can be made by those skilled in the art to which the present invention pertains without departing from the essential features of the present invention.

Accordingly, the disclosed exemplary embodiments of the present invention are not for limitation of the technical spirit of the present invention but for description thereon, so the scope of the technical spirit of the present invention is not limited by the exemplary embodiments.

The scope of the present invention should be construed by the appended claims, and all the technical spirit within the equivalency should be construed to be included in the scope of the present invention.

**Claims**

**1.** A Viterbi decoding method, comprising:

performing branch metric calculations with input data, and outputting output data;
simultaneously performing additions and comparisons of the output data by using a fed-back previous state metric;
selecting a minimum value from a result of the simultaneous additions and comparisons; and
checking errors of the inputted data by executing a trace-back algorithm and decoding the data.

2. The method as claimed in claim 1, wherein, in performing additions and comparisons, the additions are performed in a Carry Look-ahead Adder (CLA) by three bits, and a result of which is processed in a Carry SeLect Adder (CSLA).

3. The method as claimed in claim 2, wherein the three-bit CLA is configured with a CLA0 indicating that an LSB input is "0" and a CLA1 indicating that the LSB input is "1".

4. The method as claimed in claim 2, wherein the addition of three bits is carried out simultaneously, and a result is selected by a multiplexer.

5. The method as claimed in claim 1, wherein, in performing additions and comparisons, the comparisons are performed based on subtractions with use of carry-save (CS) addition, and comparing two input data through MSB of a result of the subtractions.

6. A Viterbi decoding apparatus, comprising:

an input operation unit which performs branch metric calculations with input data, and outputting output data;
an addition/comparison unit which simultaneously performs additions and comparisons of the output data by using a fed-back previous state metric;
a selection unit which selects a minimum value from a result of the simultaneous additions and comparisons; and
an output unit which checks errors of the inputted data by executing a trace-back algorithm, and decoding the data.

7. The apparatus as claimed in claim 6, wherein the addition/comparison unit is constructed with adders and comparators connected in parallel.

8. The apparatus as claimed in claim 7, wherein the adders are performed in a Carry Look-Ahead Adder) (CLA) by three bits, and a result of which is processed in a Carry SeLect Adder) (CSLA).

9. The apparatus as claimed in claim 8, wherein the three-bit CLA is configured with a CLA0 indicating that an LSB input is "0" and a CLA1 indicating that the LSB input is "1".

10. The apparatus as claimed in claim 8, wherein the addition of three bits is carried out simultaneously, and a result of which is selected by a multiplexer.

11. The apparatus as claimed in claim 7, wherein the comparators are constructed with CS adders.

FIG. 1

# FIG. 2

# FIG. 3

# FIG. 4

EP 1 783 918 A2